# EUROPEAN PATENT APPLICATION

(11) **EP 4 598 282 A1**
(43) Date of publication of application: **06.08.2025**
(21) Application number: 24875729.6
(22) Date of filing: 24.09.2024
(51) Int. Cl.: H05K 1/02

(54) **FLEXIBLE CIRCUIT BOARD AND ELECTRONIC DEVICE**

(30) Priority: 16.10.2023 CN 202311329705
(71) Applicant: Honor Device Co., Ltd., Shenzhen, Guangdong 518040 (CN)
(72) Inventor: WANG, Wenhao, Shenzhen, Guangdong 518040 (CN); LUO, Hao, Shenzhen, Guangdong 518040 (CN); HU, Li, Shenzhen, Guangdong 518040 (CN)
(74) Representative: Thun, Clemens
(86) International application number: PCT/CN2024/120524
(87) International publication number: WO 2025/082150

(57) **Abstract**

This application provides a flexible printed circuit and an electronic device. The flexible printed circuit includes a first substrate, a second substrate, and a first bonding adhesive. In a thickness direction of the flexible printed circuit, the first substrate and the second substrate are laminated, and the first bonding adhesive is bonded between the first substrate and the second substrate. The first substrate includes a first flexible board, and the first flexible board includes a first support layer and a first circuit layer. The second substrate includes a second flexible board and a second cover layer. In the thickness direction of the flexible printed circuit, the first circuit layer and the first support layer are laminated, the first circuit layer includes a plurality of first wires, and a first gap is provided between each two adjacent first wires. The second flexible board and the second cover layer are laminated. The first bonding adhesive is bonded between the first support layer and the second flexible board, and the first bonding adhesive fills the first gap and covers the first wires. The first circuit layer is directly covered by using the first bonding adhesive, without arranging a cover layer, so that a thickness of the flexible printed circuit is reduced.

## Description

This application claims priority to Chinese Patent Application No. 202311329705.3, filed with the China National Intellectual Property Administration on October 16, 2023 and entitled "FLEXIBLE PRINTED CIRCUIT AND ELECTRONIC DEVICE", which is incorporated herein by reference in its entirety.

### TECHNICAL FIELD

This application relates to the field of electronic product technologies, and in particular, to a flexible printed circuit and an electronic device.

### BACKGROUND

With the development of science and technology, a variety of electronic devices have gradually become an indispensable part of life. To improve user experience and performance, electronic devices are designed to be lighter and thinner. Therefore, how to reduce thicknesses of components in an electronic device to reduce an overall thickness of the electronic device becomes a design pain point.

A flexible printed circuit (flexible print circuit, FPC) needs to be used for designing of many electronic devices. Currently, a thickness of the flexible printed circuit inside the electronic device is large, resulting in an increase in the overall thickness of the electronic device, which is not conducive to a light and thin design of the electronic device.

### SUMMARY

This application provides a flexible printed circuit and an electronic device, to reduce a thickness of the flexible printed circuit, to reduce an overall thickness of the electronic device, which is conducive to a light and thin design of the electronic device.

According to a first aspect of this application, a flexible printed circuit is provided. The flexible printed circuit may be applied to an electronic device, to implement electrical connections between different components in the electronic device. The flexible printed circuit includes a first substrate, a second substrate, and a first bonding adhesive. In a thickness direction of the flexible printed circuit, the first substrate and the second substrate are laminated, and the first bonding adhesive is bonded between the first substrate and the second substrate.

The first substrate includes a first flexible board, and the first flexible board includes a first support layer and a first circuit layer. The second substrate includes a second flexible board and a second cover layer. In the thickness direction of the flexible printed circuit, the first circuit layer and the first support layer are laminated, the first circuit layer includes a plurality of first wires, and a first gap is provided between each two adjacent first wires. The second flexible board and the second cover layer are laminated. The first bonding adhesive is bonded between the first support layer and the second flexible board, and the first bonding adhesive fills the first gap and completely covers the first wires.

In the related art, in addition to that the first substrate includes the first flexible board, a cover layer is further laminated on the first flexible board, and then a bonding adhesive is arranged between the cover layer and the second substrate. In other words, in the related art, a thickness of the flexible printed circuit is a sum of thicknesses of the first flexible board, the cover layer covering the first flexible board, the bonding adhesive, and the second substrate. Therefore, the thickness of the flexible printed circuit in the related art is large.

In this application, the first substrate includes the first flexible board, there is no need to laminate a cover layer on the first flexible board, the first flexible board is directly bonded to a surface of the first support layer by using the first bonding adhesive, and the first bonding adhesive covers the first circuit layer. A surface of the first bonding adhesive facing away from the first support layer is bonded to the second substrate. In this way, the first bonding adhesive can cover the first circuit layer, and the first bonding adhesive can also bond the first substrate to the second substrate. In this application, the thickness of the flexible printed circuit is a sum of thicknesses of the first flexible board, the first bonding adhesive, and the second substrate. Compared with the related art, there is no need to arrange the cover layer on the first substrate, so that the thickness of the first substrate is reduced, thereby reducing the thickness of the flexible printed circuit. When the flexible printed circuit is applied to the electronic device, space that needs to be occupied in the thickness direction is reduced, which is conducive to a light and thin design of the electronic device.

In some embodiments, the first substrate further includes a first cover layer, and the first cover layer is provided with an avoidance notch; in the thickness direction of the flexible printed circuit, the first cover layer and the first flexible board are laminated, the avoidance notch runs through the first cover layer, and a part of the first wires and a part of the first support layer are opposite to the avoidance notch; and
the first bonding adhesive includes a first bonding segment, the first bonding segment is arranged in the avoidance notch, the first bonding segment is bonded between a surface of the first support layer and a surface of the second flexible board, the first bonding segment fills a first gap between a part of the first wires, and the first bonding segment completely covers the part of the first wires.

When the flexible printed circuit is applied to a foldable cellphone, the flexible printed circuit includes a deformation portion and a connecting portion, where the deformation portion is mainly configured to pass through a rotating mechanism of the cellphone, and the connecting portion is mainly configured to connect a first circuit board and a second circuit board of the cellphone, so that the first circuit board and the second circuit board can communicate through the flexible printed circuit. The deformation portion located in the rotating mechanism may be deformed as the cellphone is folded and unfolded. The first bonding adhesive does not need to be used to bond and fix regions of the first substrate and the second substrate that form the deformation portion, so that the deformation portion has good deformation performance.

In this application, the first cover layer is arranged in the region of the first substrate that forms the deformation portion, and a region of the first substrate that forms the connecting portion corresponds to the avoidance notch of the first cover layer. Then, the first bonding segment is arranged in the avoidance notch, the first bonding segment is directly connected to the surface of the first support layer, and the first bonding segment covers the first circuit layer exposed from the avoidance notch. A surface of the first bonding segment facing away from the first support layer is bonded to the second substrate. In this way, the first bonding segment can cover the first circuit layer exposed from the avoidance notch, and the first bonding segment can also bond the first substrate to the second substrate. In this case, a thickness of the region of the first substrate that forms the connecting portion does not include a thickness of the first cover layer, and a thickness of the connecting portion of the flexible printed circuit is reduced.

In some embodiments, the first bonding adhesive further includes a second bonding segment, the second bonding segment is connected to the first bonding segment in a length direction of the flexible printed circuit, and the second bonding segment is bonded between a surface of the first cover layer facing away from the first flexible board and a surface of the second flexible board facing away from the second cover layer. The second bonding segment of the first bonding adhesive and the first cover layer are laminated, to prevent the first circuit layer from being exposed due to a processing error or the like, and improve reliability of covering the first circuit layer, thereby further improving electrical connection stability of the flexible printed circuit.

In some embodiments, in the length direction of the flexible printed circuit, a length of the second bonding segment is greater than 0.5 mm, to prevent the first circuit layer from being exposed due to the processing error or the like, and improve the reliability of covering the first circuit layer, thereby further improving the electrical connection stability of the flexible printed circuit.

In some embodiments, in the thickness direction of the flexible printed circuit, a thickness of the first cover layer is greater than a thickness of the first circuit layer, and the thickness of the first cover layer is less than 30 µm; and in the thickness direction of the flexible printed circuit, a thickness of the first bonding adhesive is greater than the thickness of the first circuit layer, and the thickness of the first bonding adhesive ranges from 15 µm to 25 µm. In this way, the first cover layer can cover the first circuit layer, and a mismatch between the first cover layer and the first bonding adhesive can also be reduced, thereby increasing flatness of the flexible printed circuit.

In some embodiments, the first cover layer includes a first cover adhesive and a first protective layer; and in the thickness direction of the flexible printed circuit, the first cover adhesive is bonded between the first protective layer and the first support layer, and the first cover adhesive fills the first gap and completely covers the first wires. The first cover adhesive is used to bond the first protective layer to the first flexible board, and the first protective layer is configured to protect and support the first flexible board.

In some embodiments, the second flexible board includes a second support layer and a second circuit layer, and the second cover layer includes a second cover adhesive and a second protective layer; the first bonding adhesive is bonded between the first support layer and the second support layer; in the thickness direction of the flexible printed circuit, the second support layer and the second circuit layer are laminated, the second circuit layer includes a plurality of second wires, and a second gap is provided between each two adjacent second wires; and the second cover adhesive is bonded between the second protective layer and the second support layer, and the second cover adhesive fills the second gap and completely covers the second wires.

In some embodiments, in the thickness direction of the flexible printed circuit, a first spacing is provided between the surface of the first cover layer facing away from the first flexible board and the surface of the second flexible board facing away from the second cover layer; and in the length direction of the flexible printed circuit, the first spacing and the first bonding adhesive are sequentially arranged. The first spacing is provided, so that flexibility of the deformation portion of the flexible printed circuit can be increased, thereby reducing a bending stress of the deformation portion, and avoiding breakage caused by bending fatigue of the deformation portion.

In some embodiments, the flexible printed circuit further includes a third substrate and a second bonding adhesive, the third substrate is laminated on a side of the first substrate facing away from the second substrate, and the second bonding adhesive is bonded between the first substrate and the third substrate; and the third substrate includes a third flexible board and a third cover layer, and the third flexible board and the third cover layer are laminated in the thickness direction of the flexible printed circuit. The third flexible board may transmit electrical energy and electrical signals. A surface of the third flexible board facing away from the third cover layer is opposite to a surface of the first support layer facing away from the first cover layer. The second bonding adhesive is bonded between a surface of the third flexible board and a surface of the first support layer, and in the thickness direction of the flexible printed circuit, the second bonding adhesive is opposite to the first bonding adhesive. In other words, the flexible printed circuit is a three-layer board, so that strength of the electrical energy and/or the electrical signals transmitted by the flexible printed circuit can be increased.

In some embodiments, the third flexible board includes a third support layer and a third circuit layer, and the third cover layer includes a third cover adhesive and a third protective layer; the second bonding adhesive is bonded between the first support layer and the third support layer; in the thickness direction of the flexible printed circuit, the third support layer and the third circuit layer are laminated, the third circuit layer includes a plurality of third wires, and a third gap is provided between each two adjacent third wires; and the third cover adhesive is bonded between the third protective layer and the third support layer, and the third cover adhesive fills the third gap and completely covers the third wires.

In some embodiments, a second spacing is provided between the surface of the third flexible board facing away from the third cover layer and the surface of the first support layer facing away from the first cover layer; in the thickness direction of the flexible printed circuit, the second spacing is opposite to the first spacing; and in the length direction of the flexible printed circuit, the second spacing and the second bonding adhesive are sequentially arranged. The second spacing is provided, so that the flexibility of the deformation portion of the flexible printed circuit can be increased, thereby reducing the bending stress of the deformation portion, and avoiding the breakage caused by bending fatigue of the deformation portion.

In some embodiments, two avoidance notches are provided, the two avoidance notches are a first notch and a second notch, and in the length direction of the flexible printed circuit, the first notch and the second notch are spaced apart; and two first bonding adhesives are provided, and the two first bonding adhesives are respectively arranged in the first notch and the second notch. The foldable cellphone includes a first housing and a second housing located on two sides of the rotating mechanism. The connecting portion of the flexible printed circuit includes a first connecting portion and a second connecting portion. The first notch is located in the first connecting portion, and the second notch is located in the second connecting portion, so that thicknesses of the first connecting portion and the second connecting portion can be reduced, so that thicknesses of the first housing and the second housing can be reduced.

In some embodiments, a plurality of first substrates are provided, and in the thickness direction of the flexible printed circuit, the plurality of first substrates are sequentially laminated, and a first support layer of each of the first substrates is opposite to a first cover layer of an adjacent first substrate; and a first cover layer of each of the first substrates is provided with an avoidance notch, and the first bonding adhesive is arranged in each of the avoidance notches. "A plurality of" herein means two or more. The plurality of first substrates are provided, so that electric energy and electrical signal transmission performance of the flexible printed circuit can be increased, and the thickness of the flexible printed circuit can also be small.

According to a second aspect of this application, an electronic device is provided. The electronic device includes a first main body, a second main body, a rotating mechanism, and the flexible printed circuit according to any one of the descriptions of the first aspect of this application. The rotating mechanism is connected between the first main body and the second main body; the flexible printed circuit is arranged on the first main body, the rotating mechanism, and the second main body, to cause the first main body to be electrically connected to the second main body; and when the rotating mechanism rotates, the first main body and the second main body are unfolded or folded relative to each other.

According to a third aspect of this application, an electronic device is provided. The electronic device includes a housing, a camera, a circuit board, and the flexible printed circuit according to any one of the descriptions of the first aspect of this application, where the camera, the flexible printed circuit, and the circuit board are mounted on the housing, and the camera and the circuit board are electrically connected through the flexible printed circuit.

### BRIEF DESCRIPTION OF DRAWINGS

To describe technical solutions in embodiments of this application or the background technology more clearly, the following describes the accompanying drawings required for describing embodiments of this application or the background technology.
FIG. 1 is a schematic diagram of a structure of a foldable cellphone according to an embodiment of this application;
FIG. 2 is a schematic diagram of a structure of another state of the foldable cellphone shown in FIG. 1;
FIG. 3 is a schematic diagram of a separate structure of a partial structure of the foldable cellphone shown in FIG. 2;
FIG. 4 is a schematic diagram of an internal structure of the partial structure of the foldable cellphone shown in FIG. 3;
FIG. 5 is a schematic diagram of a cross-sectional structure of a first flexible printed circuit of the foldable cellphone shown in FIG. 3;
FIG. 6 is a schematic diagram of a cross-sectional structure of a first substrate of the first flexible printed circuit shown in FIG. 5;
FIG. 7 is a schematic diagram of a cross-sectional structure of FIG. 4 in a direction A-A;
FIG. 8 is a schematic diagram of an enlarged structure of a position A in FIG. 7;
FIG. 9 is a schematic diagram of a processing process of the first flexible printed circuit shown in FIG. 5;
FIG. 10 is a schematic diagram of a three-dimensional structure of a first cover layer of the first substrate shown in FIG. 6;
FIG. 11 is a schematic diagram of a cross-sectional structure of a first flexible printed circuit according to another embodiment of this application;
FIG. 12 is a schematic diagram of a cross-sectional structure of a first flexible printed circuit according to still another embodiment of this application; and
FIG. 13 is a schematic diagram of an enlarged structure of a position B-B in FIG. 4.

### DESCRIPTION OF EMBODIMENTS

The following describes embodiments of this application with reference to the accompanying drawings in embodiments of this application.

An embodiment of this application provides a foldable electronic device. The electronic device includes, but is not limited to, a cellphone (cellphone), a notebook computer (notebook computer), a tablet personal computer (tablet personal computer), a personal digital assistant (personal digital assistant), a wearable device (wearable device), a mobile device (mobile device), or the like. The wearable device may be specifically a wearable watch, a wearable bracelet, or the like.

In embodiments of this application, description is made below by using an example in which the foldable electronic device is a foldable cellphone 1000.

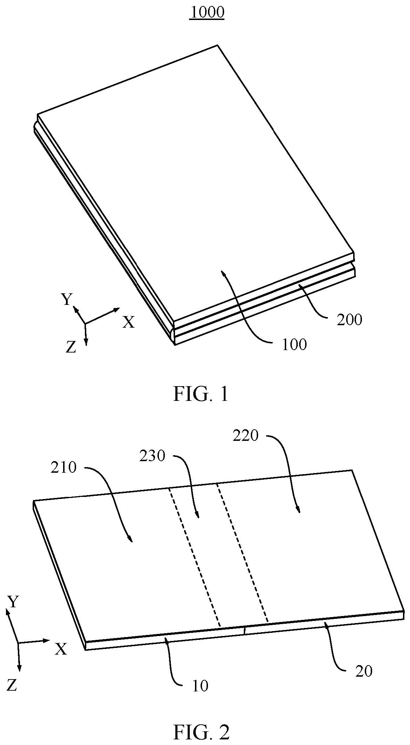

Refer to FIG. 1 and FIG. 2. FIG. 1 is a schematic diagram of a structure of a foldable cellphone 1000 according to an embodiment of this application. FIG. 2 is a schematic diagram of a structure of another state of the foldable cellphone 1000 shown in FIG. 1.

The foldable cellphone 1000 shown in FIG. 1 is in a folded state, and the foldable cellphone 1000 shown in FIG. 2 is in an unfolded state. An unfolding angle of the foldable cellphone 1000 shown in FIG. 2 is 180°. It should be noted that, angles described by using examples in embodiments of this application are allowed to have a slight deviation. For example, that the unfolding angle of the foldable cellphone 1000 shown in FIG. 2 is 180° means that the unfolding angle may be 180°, or may be approximately 180°, such as 0°, 5°, 185°, or 190°. Angles described below by using examples may be understood in the same way.

For ease of description, a length direction of the foldable cellphone 1000 is defined as a direction X, a width direction of the foldable cellphone 1000 is defined as a direction Y, and a thickness direction of the foldable cellphone 1000 is defined as a direction Z. The direction X, the direction Y, and the direction Z are perpendicular to each other.

The foldable cellphone 1000 includes a main body 100 and a display screen 200. The display screen 200 is mounted on the main body 100. The display screen 200 includes a display surface and a mounting surface, and the display surface and the mounting surface are arranged opposite to each other. The display surface is for displaying text, images, videos, or the like. The display screen 200 includes a first display part 210, a second display part 220, and a third display part 230. The third display part 230 is located between the first display part 210 and the second display part 220, and the third display part 230 is flexible and can be bent in the direction X. When the first display part 210 and the second display part 220 are not fixed, the first display part 210 and the second display part 220 can actually be bent. A direction in which a picture is displayed on the display screen may be parallel to an X-axis direction or may be parallel to a Y-axis direction.

In this embodiment, the display screen 200 is a flexible display screen, for example, an organic light-emitting diode (organic light-emitting diode, OLED) display screen, an active-matrix organic light-emitting diode (active-matrix organic light emitting diode, AMOLED) display screen, a mini organic light-emitting diode (mini organic light-emitting diode, Mini LED) display screen, a micro organic light-emitting diode (micro organic light-emitting diode) display screen, a micro organic light-emitting diode (micro organic light-emitting diode) display screen, or a quantum dot light-emitting diode (quantum dot light emitting diodes, QLED) display screen.

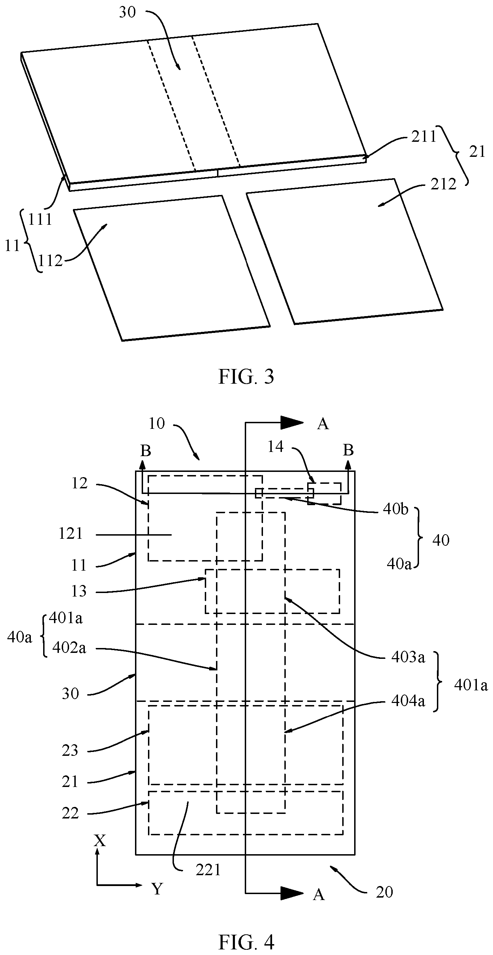

Refer to FIG. 3 and FIG. 4. FIG. 3 is a schematic diagram of a separate structure of a partial structure of the foldable cellphone shown 1000 in FIG. 2. FIG. 4 is a schematic diagram of an internal structure of the partial structure of the foldable cellphone 1000 shown in FIG. 3.

The main body 100 includes a first main body 10, a second main body 20, a rotating mechanism 30, and a flexible printed circuit 40, where the rotating mechanism 30 is connected between the first main body 10 and the second main body 20; the flexible printed circuit 40 is arranged on the first main body 10, the rotating mechanism 30, and the second main body 20, to cause the first main body 10 to be electrically connected to the second main body 20; and when the rotating mechanism 30 rotates, the first main body 10 and the second main body 20 are unfolded or folded relative to each other, so that the flexible printed circuit 40 deforms.

The display screen 200 is laminated on the first main body 10, the second main body 20, and the rotating mechanism 30. The first display part 210 is opposite to the first main body 10, the second display part 220 is opposite to the second main body 20, and the third display part 230 is opposite to the rotating mechanism 30. When the first main body 10 and the second main body 20 are unfolded relative to each other, the first main body 10 and the second main body 20 are distributed side by side in the Y-axis direction, an angle between the first main body 10 and the second main body 20 is 180°, the display screen 200 is in the unfolded state, and the rotating mechanism 30 is accommodated in the first main body 10 and the second main body 20. When the first main body 10 and the second main body 20 are folded relative to each other, the first main body 10 and the second main body 20 are laminated in a Z-axis direction, the angle between the first main body 10 and the second main body 20 is 0°, the display screen 200 is in the folded state, and a part of the rotating mechanism 30 is exposed and located between the first main body 10 and the second main body 20, to serve as an appearance member of the cellphone 1000. When the angle between the first main body 10 and the second main body 20 is ° and °, an angle range value of an assembly use tolerance is allowed to exist.

Refer to FIG. 4. The first main body 10 includes a first housing 11, a first functional component 12, a first battery 13, and a camera 14. The first functional component 12, the first battery 13, and the camera 14 are arranged inside the first housing 11, the first functional component 12 and the first battery 13 are sequentially arranged in the Y-axis direction, the first battery 13 is located at a part of the first housing 11 closer to the rotating mechanism 30, and the first functional component 12 and the camera 14 are arranged in the X-axis direction. A shape of the first battery 13 is a rectangular block, and the first battery 13 is electrically connected to the first functional component 12 to supply power to components such as the first functional component 12 and the display screen 200.

Refer to FIG. 3, the first housing 11 includes a first middle frame 111 and a first back plate 112. The first housing 11 includes the first middle frame 111 and the first back plate 112. The first middle frame 111 is provided with a first accommodating cavity. The first functional component 12, the first battery 13, and the camera 14 are arranged inside the first accommodating cavity. The first back plate 112 is fixed to a side of the first middle frame 111, to protect the first middle frame 111, the first functional component 12, the first battery 13, and the camera 14. A side of the first middle frame 111 facing away from the first back plate 112 is used to support the first display part 210 of the display screen 200.

The first functional component 12 may include components such as a first circuit board 121, a processor 122, a memory 123, a shielding cover 124, and a communication module. The processor 122, the memory 123, and the communication module are integrated on the first circuit board 121. The memory 123 and the communication module each are electrically connected to the processor 122. The memory 123 is configured to store instructions and data. The shielding cover 124 is configured to protect the processor 122 and the memory 123. The communication module may implement wireless communication of the cellphone 1000, such as G/G/G, and the communication module may also implement wireless communication of the cellphone 1000, for example, a wireless local area network (wireless local area networks, WLAN), Bluetooth (bluetooth, BT), and a near field communication (near field communication, NFC) technology. The first functional component 12 may also include components for implementing other functions, which are not listed one by one herein.

A lens of the camera 14 faces a camera window of the first back plate 112, the camera 14 is configured to take photos or perform photographing, and an optical image generated by an object through the lens of the camera 14 is projected onto a photosensitive element of the camera. The photosensitive element may be a charge coupled device (charge coupled device, CCD) or a complementary metal-oxide-semiconductor (complementary metal-oxide-semiconductor, CMOS) phototransistor. The camera 14 may include a front-facing camera and a rear-facing camera. There may be one or more front-facing cameras, and there may also be one or more rear-facing cameras.

Refer to FIG. 4. The second main body 20 includes a second housing 21, a second functional component 22, and a second battery 23. The second functional component 22 and the second battery 23 are arranged inside the second housing 21. The second functional component 22 and the second battery 23 are arranged in the Y-axis direction, and the second battery 23 is located at a part of the second housing 21 closer to the rotating mechanism 30. A shape of the second battery 23 is a rectangular block, and the second battery 23 is electrically connected to the second functional component 22 to supply power to components such as the second functional component 22 and the display screen 200.

Refer to FIG. 3. The second housing 21 includes a second middle frame 211 and a second back plate 212. The second middle frame 211 is provided with a second accommodating cavity. The second functional component 22 is arranged inside the second accommodating cavity. The second back plate 212 is fixed to a side of the second middle frame 211, to protect the second middle frame 211, the second functional component 22, and the second battery 23. A side of the second middle frame 211 facing away from the second back plate 212 is used to support the second display part 220 of the display screen 200.

The second functional component 22 may include components such as a second circuit board 221, an antenna, a motor, and a sensor module, and the antenna, the motor, and the sensor module are integrated on the second circuit board 221. The motor may generate a vibration prompt, which may be specifically used for an incoming call vibration prompt or a touch vibration feedback. The sensor module includes a gyroscope sensor, a temperature sensor, and the like. The gyroscope sensor may be configured to determine a motion posture of the cellphone 1000, and the temperature sensor is configured to detect a temperature, so that the processor 122 executes a temperature processing policy based on the temperature detected by the temperature sensor, to prevent the cellphone 1000 from being overheated or from being abnormal due to a low temperature. The second functional component 22 may also include components for implementing other functions, which are not listed one by one herein.

Still refer to FIG. 4. Two flexible printed circuits 40 may be provided, and the two flexible printed circuits 40 are a first flexible printed circuit 40a and a second flexible printed circuit 40b. Structures of the first flexible printed circuit 40a and the second flexible printed circuit 40b may be the same, and shapes and sizes of the first flexible printed circuit 40a and the second flexible printed circuit 40b may be the same or different. The first flexible printed circuit 40a is configured to connect the first circuit board 121 and the second circuit board 221, and there may be one or two first flexible printed circuits 40a, or the like. The second flexible printed circuit 40b is configured to connect the camera 14 and the first circuit board 121.

Specifically, the first flexible printed circuit 40a penetrates the first housing 11, the rotating mechanism 30, and the second housing 21, which may be understood as that the first flexible printed circuit 40a is partially located in the first housing 11, partially penetrates the rotating mechanism 30 and extends into the second housing 21, and is also partially located inside the rotating mechanism 30. The first flexible printed circuit 40a extends in the X-axis direction, and two opposite sides of the first flexible printed circuit 40a in the X-axis direction are respectively fixedly connected to the first circuit board 121 and the second circuit board 221, to implement an electrical connection between the first circuit board 121 and the second circuit board 221.

The second flexible printed circuit 40b is arranged in the first housing 11, the second flexible printed circuit 40b extends in the Y-axis direction, and two opposite sides of the second flexible printed circuit 40b in the Y-axis direction are respectively fixedly connected to the first circuit board 121 and the camera 14, to implement an electrical connection between the first circuit board 121 and the camera 14.

The first flexible printed circuit 40a includes a connecting portion 401a and a deformation portion 402a, and the connecting portion 401a includes a first connecting portion 403a and a second connecting portion 404a. In the X-axis direction, the first connecting portion 403a, the deformation portion 402a, and the second connecting portion 404a are sequentially connected. The deformation portion 402a is partially located in the rotating mechanism 30, partially located in the first housing 11, and partially located in the second housing 21. The first connecting portion 403a is located in the first housing 11, and the second connecting portion 404a is located in the second housing 21. The deformation portion 402a is configured to be bent when the first main body 10 and the second main body 20 are unfolded relative to each other. The bending herein means that a part of the deformation portion 402a may form wave-like wrinkles. The deformation portion 402a extends when the first main body 10 and the second main body 20 are folded relative to each other. The extending herein means that the wave-like wrinkles of the deformation portion 402a are unfolded, and the extending herein does not mean that the deformation portion 402a cannot be deformed. In this case, the deformation portion 402a may be entirely arcuate, to prevent the first flexible printed circuit 40a from being torn as the first main body 10 and the second main body 20 rotate. The first connecting portion 403a is configured to connect to the first circuit board 121, and the second connecting portion 404a is configured to connect to the second circuit board 221. The first circuit board 121 and the second circuit board 221 are connected through the first flexible printed circuit 40a, to implement an electrical connection between a component in the first functional component 12 and a component in the second functional component 22. For example, components such as the antenna, the motor, and the sensor module in the second functional component 22 can be connected to the processor 122 in the first functional component 12 through the first flexible printed circuit 40a. The antenna in the second functional component 22 may be further connected to the communication module in the first functional component 12 through the first flexible printed circuit 40a.

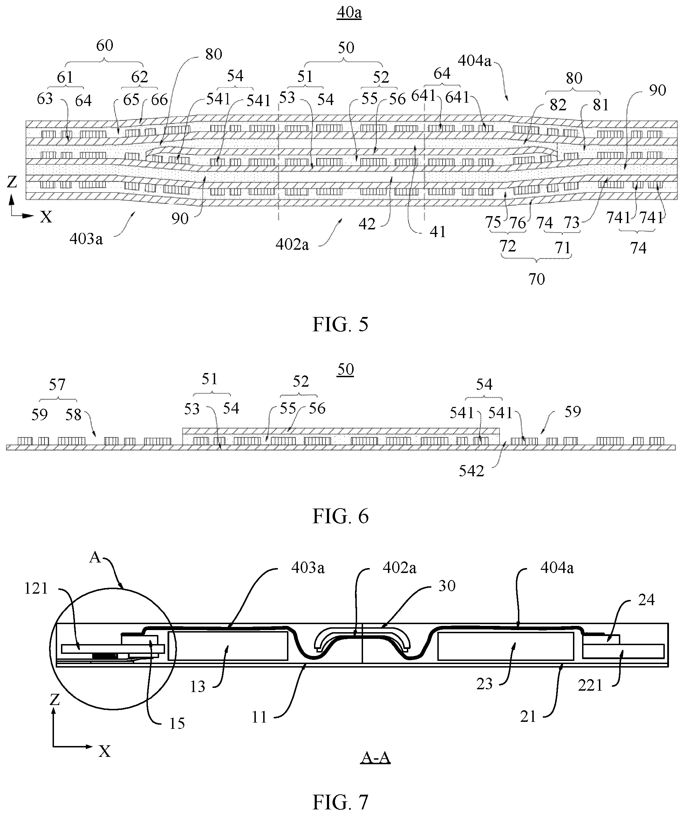

Refer to FIG. 5. FIG. 5 is a schematic diagram of a cross-sectional structure of a first flexible printed circuit 40a of the foldable cellphone 1000 shown in FIG. 3.

The first flexible printed circuit 40a includes a first substrate 50, a second substrate 60, a third substrate 70, a first bonding adhesive 80, and a second bonding adhesive 90. The first bonding adhesive 80 and the second bonding adhesive 90 are a bonding sheet (bonding sheet, BS) of the first flexible printed circuit 40a.

In the Z-axis direction, the second substrate 60, the first substrate 50, and the third substrate 70 are sequentially laminated, the first bonding adhesive 80 is bonded between the first substrate 50 and the second substrate 60, and the second bonding adhesive 90 is bonded between the first substrate 50 and the third substrate 70. In other words, in the Z-axis direction, the second substrate 60, the first bonding adhesive 80, the first substrate 50, the second bonding adhesive 90, and the third substrate 70 are sequentially laminated.

Refer to FIG. 6. FIG. 6 is a schematic diagram of a cross-sectional structure of a first substrate 50 of the first flexible printed circuit 40a shown in FIG. 5.

The first substrate 50 includes a first flexible board 51 and a first cover layer 52. The first flexible board 51 and the first cover layer 52 are laminated in the Z-axis direction. The first flexible board 51 may be a flexible copper clad laminate (flexible copper clad laminate, FCCL). The first flexible board 51 includes a first support layer 53 and a first circuit layer 54, and the first cover layer 52 includes a first cover adhesive 55 and a first protective layer 56. In the Z-axis direction, the first protective layer 56, the first cover adhesive 55, and the first support layer 53 are sequentially laminated, the first circuit layer 54 is fixed to a surface of the first support layer 53 facing the first cover adhesive 55, and the first circuit layer 54 is covered by the first cover adhesive 55. The first circuit layer 54 includes a plurality of first wires 541, and a first gap 542 is provided between each two adjacent first wires 541. More specifically, a top surface of the first protective layer 56 is used to face the second substrate 60, a bottom surface of the first protective layer 56 is fixedly connected to a top surface of the first cover adhesive 55, a bottom surface of the first cover adhesive 55 is fixedly connected to a top surface of the first support layer 53, the first circuit layer 54 is fixed to the top surface of the first support layer 53, and a bottom surface of the first support layer 53 is used to face the third substrate 70.

The first cover layer 52 is provided with an avoidance notch 57. In the Z-axis direction, the avoidance notch 57 runs through the first cover layer 52, so that a part of the first circuit layer 54 and a part of the top surface of the first support layer 53 are exposed relative to the first cover layer 52, and the part of the first circuit layer 54 and the part of the top surface of the first support layer 53 are opposite to the second substrate 60. In other words, in the Z-axis direction, the avoidance notch 57 runs through the first cover adhesive 55 and the first protective layer 56, and a part of the first wires 541 and a part of the first support layer 53 are opposite to the avoidance notch 57. The avoidance notch 57 is configured to arrange the first bonding adhesive 80. In this embodiment, two avoidance notches 57 are provided, the two avoidance notches 57 are a first notch 58 and a second notch 59, and in the X-axis direction, the first notch 58 and the second notch 59 are spaced apart.

Still refer to FIG. 5. The second substrate 60 includes a second flexible board 61 and a second cover layer 62 (cover layer, CVL). The second flexible board 61 and the second cover layer 62 are laminated in the Z-axis direction. The second flexible board 61 may be a flexible copper clad laminate (flexible copper clad laminate, FCCL). The second flexible board 61 includes a second support layer 63 and a second circuit layer 64, and the second cover layer 62 includes a second cover adhesive 65 and a second protective layer 66. In the Z-axis direction, the second protective layer 66, the second cover adhesive 65, and the second support layer 63 are sequentially laminated, the second circuit layer 64 is fixed to a surface of the second support layer 63 facing the second cover adhesive 65, and the second circuit layer 64 is covered by the second cover adhesive 65. The second circuit layer 64 includes a plurality of second wires 641, and a second gap is provided between each two adjacent second wires 641. More specifically, a top surface of the second protective layer 66 is used to form a top outer surface of the first flexible printed circuit 40a, a bottom surface of the second protective layer 66 is fixedly connected to a top surface of the second cover adhesive 65, a bottom surface of the second cover adhesive 65 is fixedly connected to a top surface of the second support layer 63, the second circuit layer 64 is fixed to the top surface of the second support layer 63, and the second cover adhesive 65 fills the second gap and completely covers the second wires 641. One part of a bottom surface of the second support layer 63 is used to face the top surface of the first protective layer 56, and the other part of the bottom surface of the second support layer 63 is used to be opposite to a part of the top surface of the first support layer 53 together with a part of the first circuit layer 54 located at the avoidance notch 57.

Still refer to FIG. 5. The third substrate 70 includes a third flexible board 71 and a third cover layer 72. The third flexible board 71 and the third cover layer 72 are laminated in the Z-axis direction. The third flexible board 71 may be a flexible copper clad laminate (flexible copper clad laminate, FCCL). The third flexible board 71 includes a third support layer 73 and a third circuit layer 74, and the third cover layer 72 includes a third cover adhesive 75 and a third protective layer 76. In the Z-axis direction, the third support layer 73, the third cover adhesive 75, and the third protective layer 76 are sequentially laminated, the third circuit layer 74 is fixed to a surface of the third support layer 73 facing the third cover adhesive 75, and the third circuit layer 74 is covered by the third cover adhesive 75. The third circuit layer 74 includes a plurality of third wires 741, and a third gap is provided between each two adjacent third wires 741. More specifically, a top surface of the third support layer 73 is used to face the bottom surface of the first support layer 53, a bottom surface of the third support layer 73 is fixedly connected to a top surface of the third cover adhesive 75, a bottom surface of the third cover adhesive 75 is fixedly connected to a top surface of the third protective layer 76, the third circuit layer 74 is fixed to the bottom surface of the third support layer 73, and the third cover adhesive 75 fills the third gap and completely covers the third wires 741. A bottom surface of the third protective layer 76 is used to form a bottom outer surface of the first flexible printed circuit 40a.

The first support layer 53, the second support layer 63, the third support layer 73, the first protective layer 56, the second protective layer 66, and the third protective layer 76 each may be made of a polyimide (polyimide, PI) material. The first circuit layer 54, the second circuit layer 64, and the third circuit layer 74 each may be a copper foil circuit layer. The first support layer 53 is configured to support the first circuit layer 54, and may have an insulation function. The second support layer 63 is configured to support the second circuit layer 64, and may have an insulation function. The third support layer 73 is configured to support the third circuit layer 74, and has an insulation function. The first protective layer 56 is configured to protect and support the first flexible board 51, the second protective layer 66 is configured to protect and support the second flexible board 61, and the third protective layer 76 is configured to protect and support the third flexible board 71. The first cover adhesive 55 is used to bond the first protective layer 56 to the first flexible board 51, the second cover adhesive 65 is used to bond the second protective layer 66 to the second flexible board 61, and the third cover adhesive 75 is used to bond the third protective layer 76 to the third flexible board 71.

In the Z-axis direction, when the second substrate 60, the first substrate 50, and the third substrate 70 are sequentially laminated, the top surface of the second protective layer 66 is the top outer surface of the first flexible printed circuit 40a, and the bottom surface of the third protective layer 76 is the bottom outer surface of the first flexible printed circuit 40a. The top surface of the first protective layer 56 is opposite to one part of the bottom surface of the second support layer 63, and the other part of the bottom surface of the second support layer 63, the avoidance notch 57, and a part of the first circuit layer 54 are opposite to a part of the top surface of the first support layer 53. The bottom surface of the first support layer 53 is opposite to the top surface of the third support layer 73.

Still refer to FIG. 5. The first bonding adhesive 80 includes a first bonding segment 81 and a second bonding segment 82, and the first bonding segment 81 and the second bonding segment 82 are connected in the X-axis direction. The first bonding segment 81 is arranged in the avoidance notch 57 of the first cover layer 52, a top surface of the first bonding segment 81 is bonded to the bottom surface of the second support layer 63, a bottom surface of the first bonding segment 81 is bonded to the top surface of the first support layer 53 exposed from the avoidance notch 57, the first bonding segment 81 fills a first gap 542 directly facing the avoidance notch 57, and the first bonding segment 81 completely covers the first wire 541 directly facing the avoidance notch 57. The second bonding segment 82 is arranged between the second support layer 63 and the first protective layer 56, a top surface of the second bonding segment 82 is bonded to the bottom surface of the second support layer 63, and a bottom surface of the second bonding segment 82 is bonded to the top surface of the first protective layer 56. In addition, the second bonding segment 82 does not completely cover the second support layer 63 and the first protective layer 56, and a spacing is provided between regions of the second support layer 63 and the first protective layer 56 that are not covered by the second bonding segment 82. The spacing is a first spacing 41. In the X-axis direction, the first spacing 41 and the first bonding adhesive 80 are sequentially arranged.

It may be understood that, two first bonding adhesives 80 are provided, the two first bonding adhesives 80 are spaced apart in the X-axis direction, and the first spacing 41 is located between the two first bonding adhesives 80. One of the first bonding adhesives 80 is arranged in the first notch 58, and the other of the first bonding adhesives 80 is arranged in the second notch 59.

In the X-axis direction, a length L1 of the second bonding segment 82 is greater than 0.5 mm. In other words, a length of a region of the first bonding adhesive 80 laminated with the first cover layer 52 is greater than 0.5 mm. L1 may be specifically 0.5 mm, 0.7 mm, 1 mm, 1.2 mm, 1.4 mm, 1.6 mm, 1.8 mm, 2 mm, or the like. The second bonding segment 82 of the first bonding adhesive 80 and the first cover layer 52 are laminated, to prevent the first circuit layer 54 from being exposed due to a processing error or the like, and improve reliability of covering the first circuit layer 54, thereby further improving electrical connection stability of the first flexible printed circuit 40a.

The second bonding adhesive 90 is arranged between the first support layer 53 and the third support layer 73, a top surface of the second bonding adhesive 90 is bonded to the bottom surface of the second support layer 63, and a bottom surface of the second bonding adhesive 90 is bonded to the top surface of the third support layer 73. In addition, the second bonding adhesive 90 does not completely cover the second support layer 63 and the third support layer 73, and a spacing is provided between regions of the second support layer 63 and the third support layer 73 that are not covered by the second bonding adhesive 90. The spacing is a second spacing 42. In the X-axis direction, the second spacing 42 and the second bonding adhesive 90 are sequentially arranged. In the Z-axis direction, the first spacing 41 is opposite to the second spacing 42, and the first bonding adhesive 80 is opposite to the second bonding adhesive 90.

It may be understood that, two second bonding adhesives 90 are provided, the two second bonding adhesives 90 are spaced apart in the X-axis direction, and the second spacing 42 is located between the two second bonding adhesives 90. In the Z-axis direction, the two second bonding adhesives 90 are respectively opposite to the two first bonding adhesives 80.

Still refer to FIG. 5. In this embodiment, in the Z-axis direction, parts of the first substrate 50, the second substrate 60, and the third substrate 70 opposite to the first spacing 41 form the deformation portion 402a. Parts of the first substrate 50, the second substrate 60, and the third substrate 70 located on a left side of the first spacing 41, and the first bonding adhesive 80 and the second bonding adhesive 90 located on the left side form the first connecting portion 403a. Parts of the first substrate 50, the second substrate 60, and the third substrate 70 located on a right side of the first spacing 41, and the first bonding adhesive 80 and the second bonding adhesive 90 located on the right side form the second connecting portion 404a. In other words, the deformation portion 402a is not provided with the first bonding adhesive 80 and the second bonding adhesive 90, but is provided with the first spacing 41 and the second spacing 42, so that flexibility of the deformation portion 402a can be increased, thereby reducing a bending stress of the deformation portion 402a, and avoiding breakage caused by bending fatigue of the deformation portion 402a. The first connecting portion 403a and the second connecting portion 404a each are provided with the first bonding adhesive 80 and the second bonding adhesive 90, so that the first connecting portion 403a and the second connecting portion 404a can have stable forms, and circuit conduction can be ensured.

In the related art, the avoidance notch 57 is not provided on the first substrate 50, and thicknesses of all regions of the connecting portion 401a of the first flexible printed circuit 40a are a sum of thicknesses of the following components: the second substrate 60, the first bonding adhesive 80, the first cover layer 52 of the first substrate 50, the first flexible board 51 of the first substrate 50, the second bonding adhesive 90, and the third substrate 70. In other words, in the related art, all regions of the first circuit layer 54 of the first substrate 50 are covered by the first cover layer 52, and then the first bonding adhesive 80 is arranged on the first cover layer 52. Such a solution results in a large thickness of the first flexible printed circuit 40a.

In this embodiment, the avoidance notch 57 is provided on the first substrate 50, then the first bonding segment 81 of the first bonding adhesive 80 is used to directly connect to the first support layer 53 of the first substrate 50, and the first bonding segment 81 is used to directly cover the first circuit layer 54. In addition, there is no need to first cover the first circuit layer 54 by using the first cover layer 52 and then cover the first cover layer 52 by using the first bonding adhesive 80. In other words, in this embodiment, a thickness of a position on which the avoidance notch 57 is provided on the first substrate 50 is a sum of thicknesses of the following components: the second substrate 60, the first bonding adhesive 80, the first flexible board 51 of the first substrate 50, the second bonding adhesive 90, and the third substrate 70. It can be seen that, compared with the related art, a quantity of components whose regions are laminated in at least a partial region of the first flexible printed circuit 40a provided in this embodiment is reduced. Specifically, the avoidance notch 57 is provided on the first cover layer 52, so that a part of the first circuit layer 54 and a part of a surface of the first support layer 53 are exposed from the avoidance notch 57, and then the first bonding segment 81 is used to directly cover the part of the circuit layer. In this case, the first bonding segment 81 can cover the first circuit layer 54, can also fix the first substrate 50 and the second substrate 60, and can also reduce a thickness of the at least a partial region of the first flexible printed circuit 40a.

Refer to FIG. 7. FIG. 7 is a schematic diagram of a cross-sectional structure of FIG. 4 in a direction A-A.

In this embodiment, when the first flexible printed circuit 40a is mounted on the first housing 11, the rotating mechanism 30, and the second housing 21, one part of the first connecting portion 403a of the first flexible printed circuit 40a and the first battery 13 are laminated in the Z-axis direction. After a thickness of the first connecting portion 403a is reduced, a total thickness of the first connecting portion 403a and the first battery 13 is reduced, and space requirements of the first connecting portion 403a and the first battery 13 in the Z-axis direction are correspondingly reduced, so that a thickness of a part of the first housing 11 on which the first battery 13 is mounted can be reduced. This is conducive to a light and thin design of the cellphone 1000.

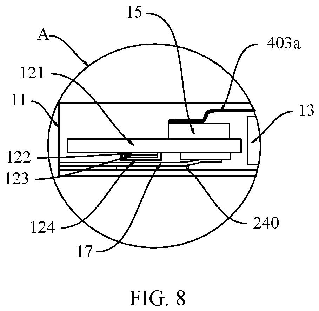

Refer to FIG. 8. FIG. 8 is a schematic diagram of an enlarged structure of a position A in FIG. 7.

The other part of the first connecting portion 403a is connected to the first circuit board 121 through a first connector 15, to implement an electrical connection between the first flexible printed circuit 40a and the first circuit board 121. The first connector 15 and the first connecting portion 403a are laminated on a top surface of the first circuit board 121. Components such as the processor 122, the memory 123, a heat dissipation plate 17, a shielding cover 124, and a flexible board 240 of the display screen 200 are sequentially laminated on a side of the bottom surface of the first circuit board 121. The heat dissipation plate 17 is fixed on the first housing 11. The heat dissipation plate 17 is configured to dissipate heat for the memory 123 and the processor 122. Therefore, a total thickness space requirement of a position of the first circuit board 121 is a sum of the following components: the first connector 15, the first connecting portion 403a of the first flexible printed circuit 40a, the first circuit board 121, the processor 122, the heat dissipation plate 17, the shielding cover 124, and the flexible board 240 of the display screen 200. It can be seen that, thickness space of the position of the first circuit board 121 is very tight, and the use of the thickness space herein is a key position for the light and thin design of the cellphone 1000. In this embodiment, the avoidance notch 57 is provided on the first cover layer 52 of the first substrate 50, so that a thickness of the first connecting portion 403a is reduced, thereby reducing a requirement for the thickness space of the position of the first circuit board 121, and resolving a key problem for the light and thin design of the cellphone 1000.

Still refer to FIG. 7. One part of the second connecting portion 404a of the first flexible printed circuit 40a and the second battery 23 are laminated. After a thickness of the second connecting portion 404a is reduced, a total thickness of the second connecting portion 404a and the second battery 23 is reduced, and space requirements of the second connecting portion 404a and the second battery 23 in the Z-axis direction are correspondingly reduced, so that a thickness of a part of the second housing 21 on which the second battery 23 is mounted can be reduced. The other part of the second connecting portion 404a of the first flexible printed circuit 40a is connected to the second circuit board 221 through a second connector 24, to implement an electrical connection between the first flexible printed circuit 40a and the second circuit board 221. If the thickness of the second connecting portion 404a is reduced, a total thickness of the second connecting portion 404a, the second circuit board 221, and the second connector 24 is reduced, and space requirements of the second connecting portion 404a, the second circuit board 221, and the second connector 24 in the Z-axis direction are correspondingly reduced, so that a thickness of a part of the first housing 11 on which the second circuit board 221 is mounted can be reduced. This is conducive to the light and thin design of the cellphone 1000.

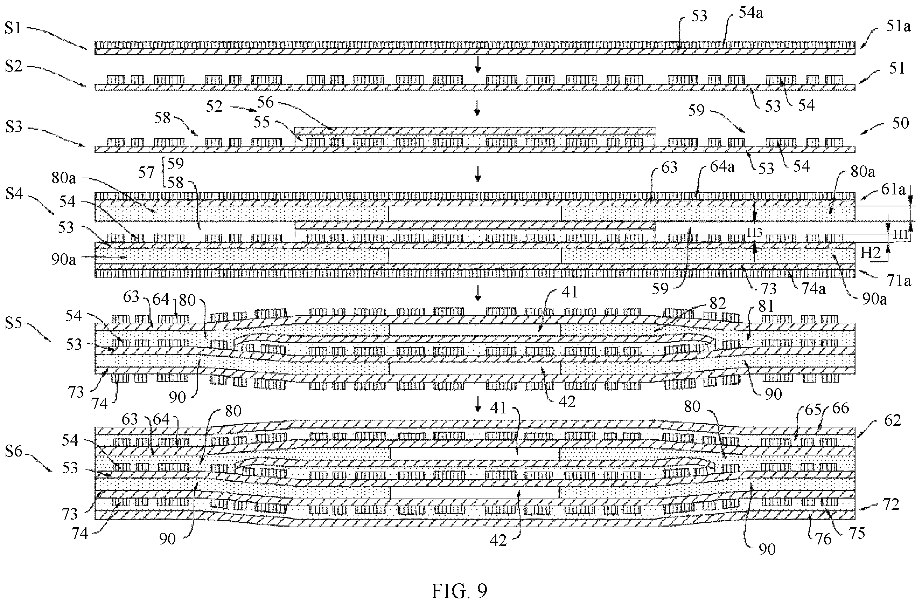

Refer to FIG. 9. FIG. 9 is a schematic diagram of a processing process of the first flexible printed circuit 40a shown in FIG. 5.

In this embodiment, a process of preparing the first flexible printed circuit 40a is as follows.

Step S1: Provide a first original board 51a, where the first original board 51a includes a first copper foil layer 54a and a first support layer 53, and the first copper foil layer 54a is fixed to a surface of the first support layer 53.

Step S2: Etch the first copper foil layer 54a, so that the first copper foil layer 54a becomes a first circuit layer 54, and in this case, the first original board 51a becomes a first flexible board 51.

Step S3: Provide a first cover layer 52, where the first cover layer 52 includes a first cover adhesive 55 and a first protective layer 56; cut an avoidance notch 57 on the first cover layer 52; and laminate the first cover layer 52 on a surface of the first support layer 53, and cause the first cover layer 52 to cover the first circuit layer 54. In this case, a part of the first circuit layer 54 and a part of the surface of the first support layer 53 are exposed from the avoidance notch 57. In this case, the first cover layer 52 and the first flexible board 51 form a first substrate 50.

A size L1 of the avoidance notch 57 in an X-axis direction is greater than 1 mm, and a size L2 of the avoidance notch 57 in a Y-axis direction is greater than 1 mm. Two avoidance notches 57 are provided, the two avoidance notches 57 are a first notch 58 and a second notch 59, and in the X-axis direction, the first notch 58 and the second notch 59 are spaced apart. A spacing L3 between the first notch 58 and the second notch 59 is greater than 2 mm. Therefore, the avoidance notch 57 can be easily formed by cutting and processing, and the first cover layer 52 cannot be crimped or broken.

Step S4: Laminate two first original adhesives 80a on the first cover layer 52, so that one part of the first original adhesives is opposite to the first cover layer 52, and the other part of the first original adhesives is opposite to the avoidance notch 57; laminate two second original adhesives 90a on the first flexible board 51, so that the two second original adhesives are respectively opposite to the two first original adhesives in a Z-axis direction; and laminate a second original board 61a on an upper side of the first original adhesives, and laminate a third original board 71a on a lower side of the second original adhesives, where the second original board 61a includes a second copper foil layer 64a and a second support layer 63, and the second copper foil layer 64a is fixed to a surface of the second support layer 63; and the third original board 71a includes a third copper foil layer 74a and a third support layer 73, and the third copper foil layer 74a is fixed to a surface of the third support layer 73. In this case, in the Z-axis direction, a spacing is provided between the first cover layer 52 and the second original board 61a, and the spacing is also located between the two first original adhesives. In the Z-axis direction, a spacing is provided between the first flexible board 51 and the third original board 71a, and the spacing is also located between the two second original adhesives.

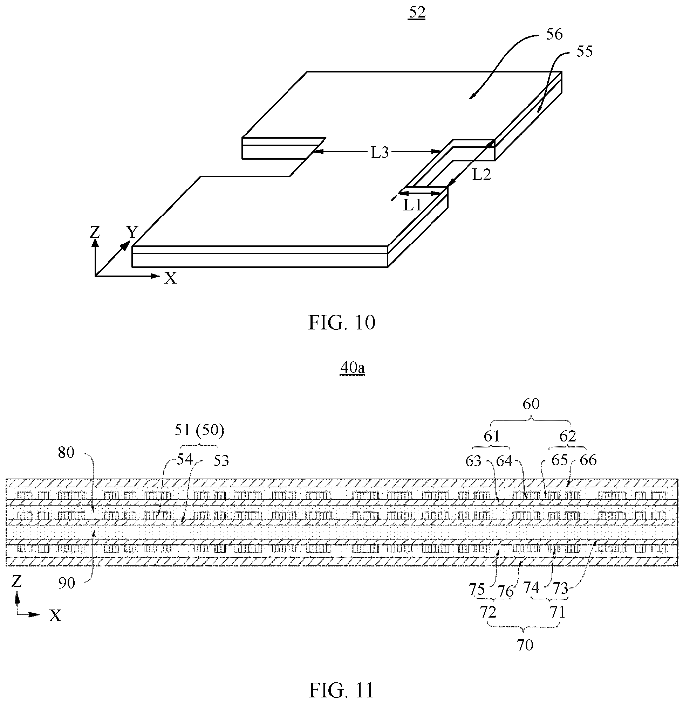

Refer to FIG. 10. FIG. 10 is a schematic diagram of a three-dimensional structure of a first cover layer 52 of the first substrate 50 shown in FIG. 6.

In the Z-axis direction, a thickness of the first original adhesive is greater than a thickness of the first circuit layer 54, and a thickness H1 of the first original adhesive ranges from 15 µm to 25 µm. In this way, a thickness of a finally formed first bonding adhesive 80 is greater than a thickness H2 of the first circuit layer 54, and the thickness of the first bonding adhesive 80 ranges from 15 µm to 25 µm. The thickness of the first bonding adhesive 80 may be specifically 15 µm, µm, 19 µm, 21 µm, 23 µm, 25 µm, or the like. In this way, the first bonding adhesive 80 can cover the first circuit layer 54. In the Z-axis direction, a thickness H3 of the first cover layer 52 is greater than the thickness H2 of the first circuit layer 54, and the thickness of the first cover layer 52 is less than 30 µm. In this way, the first cover layer 52 can cover the first circuit layer 54, and a mismatch between the first cover layer 52 and the first bonding adhesive 80 can also be reduced, thereby increasing flatness of the first flexible printed circuit 40a.

Step S5: Etch the second copper foil layer 64a, so that the second copper foil layer 64a becomes a second circuit layer 64, and in this case, the second original board 61a becomes a second flexible board 61; and etch the third copper foil layer 74a, so that the third copper foil layer 74a becomes a third circuit layer 74, and in this case, the third original board 71a becomes a third flexible board 71. One part of one of the first original adhesives gradually flows into the first notch 58 to become one first bonding segment 81, and the other part of one of the first original adhesives is deformed to become one second bonding segment 82. One part of the other one of the first original adhesives gradually flows into the second notch 59 to become the other first bonding segment 81, and the other part of the other one of the first original adhesives is deformed to become the other second bonding segment 82. The first bonding segment 81 and the second bonding segment 82 form the first bonding adhesive 80.

In this case, parts of the first flexible board 51, the second flexible board 61, and the third flexible board 71 corresponding to the first notch 58 and the second notch 59 are deformed, and the second original adhesive is also deformed to become a second bonding adhesive 90.

Step S6: Provide a second cover layer 62 and a third cover layer 72, fix the second cover layer 62 to the second flexible board 61, and fix the third cover layer 72 to the third flexible board 71. The second cover layer 62 and the second flexible board 61 form a second substrate 60, and the third cover layer 72 and the third flexible board 71 form a third substrate 70.

In other embodiments, regardless of which position on the first flexible printed circuit 40a that needs to be reduced in thickness, the avoidance notch 57 may be provided at a position corresponding to the first cover layer 52, to meet a requirement of the position on the first flexible printed circuit 40a that needs to be reduced in thickness. One, three, or four avoidance notches 57 may also be provided, or the like. This is not limited in this application.

Refer to FIG. 11. FIG. 11 is a schematic diagram of a cross-sectional structure of a first flexible printed circuit 40a according to another embodiment of this application.

In another embodiment, a first cover layer 52 of a first substrate 50 may be entirely removed, that is, no first cover layer 52 is arranged in all regions of the first flexible printed circuit 40a, so that thicknesses of all the regions of the first flexible printed circuit 40a can be reduced. In other words, the first substrate 50 includes only a first flexible board 51, and the first flexible board 51 includes a first support layer 53 and a first circuit layer 54. A second substrate 60 and a third substrate 70 are respectively located on two sides of the first substrate 50 in a Z-axis direction. The first substrate 50 and the second substrate 60 are bonded and fixed through a first bonding adhesive 80, and the first substrate 50 and the third substrate 70 are bonded and fixed through a second bonding adhesive 90. The second substrate 60 includes a second flexible board 61 and a second cover layer 62, the second flexible board 61 includes a second support layer 63 and a second circuit layer 64, and the second cover layer 62 includes a second cover adhesive 65 and a second protective layer 66. The third substrate 70 includes a third flexible board 71 and a third cover layer 72, the third flexible board 71 includes a third support layer 73 and a third circuit layer 74, and the third cover layer 72 includes a third cover adhesive 75 and a third protective layer 76. In this embodiment, the first bonding adhesive 80 can cover the first circuit layer 54, and the first bonding adhesive 80 can also bond the first substrate 50 to the second substrate 60. Compared with the related art, there is no need to arrange the cover layer on the first substrate, thereby reducing a thickness of a flexible printed circuit 40.

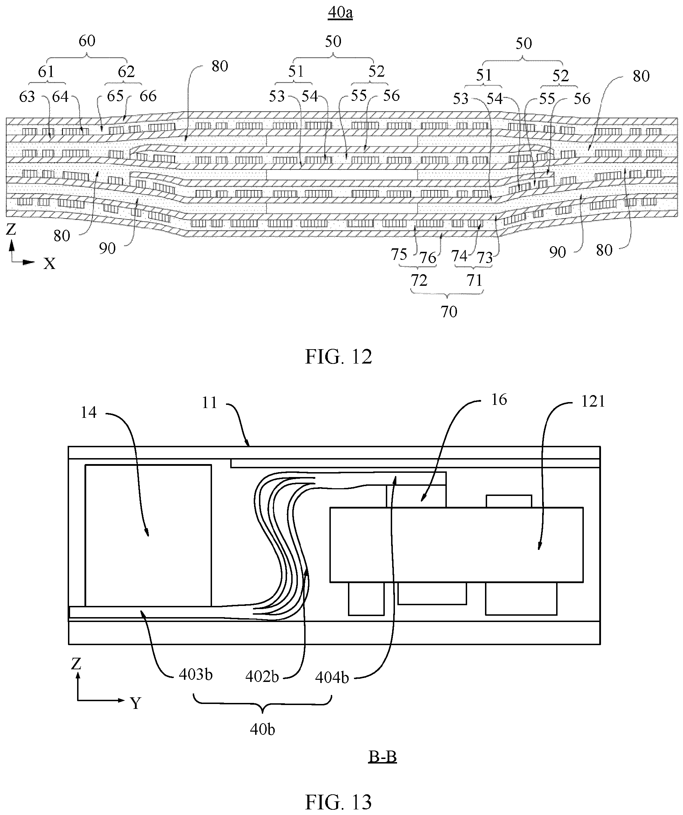

Refer to FIG. 12. FIG. 12 is a schematic diagram of a cross-sectional structure of a first flexible printed circuit 40a according to still another embodiment of this application.

In another embodiment, two first substrates 50 may be arranged. A second substrate 60, a first bonding adhesive 80, a first substrate 50, a first bonding adhesive 80, a first substrate 50, a second bonding adhesive 90, and a third substrate 70 are laminated in a Z-axis direction. An avoidance notch 57 is arranged on a first cover layer 52 in each of the two first substrates 50, so that a thickness of the first flexible printed circuit 40a can be reduced. The first substrate 50 includes a first flexible board 51 and a first cover layer 52, the first flexible board 51 includes a first support layer 53 and a first circuit layer 54, and the first cover layer 52 includes a first cover adhesive 55 and a first protective layer 56. The second substrate 60 includes a second flexible board 61 and a second cover layer 62, the second flexible board 61 includes a second support layer 63 and a second circuit layer 64, and the second cover layer 62 includes a second cover adhesive 65 and a second protective layer 66. The third substrate 70 includes a third flexible board 71 and a third cover layer 72, the third flexible board 71 includes a third support layer 73 and a third circuit layer 74, and the third cover layer 72 includes a third cover adhesive 75 and a third protective layer 76.

FIG. 13 is a schematic diagram of an enlarged structure of a position B-B in FIG. 4.

In this embodiment, for a structure of the second flexible printed circuit 40b, refer to the foregoing description of the structure of the first flexible printed circuit 40a. A first connecting portion 403b of the second flexible printed circuit 40b is connected to the camera 14, and a second connecting portion 404b of the second flexible printed circuit 40b is connected to the first circuit board 121 through a third connector 16. A deformation portion 402b extends from a Z-axis positive direction to a Z-axis negative direction, and is deformed, so that the camera 14 and the first circuit board 121 are electrically connected smoothly. If a thickness of the first connecting portion 403b is reduced, space requirements of the first connecting portion 403b and the camera 14 in the Z-axis direction are correspondingly reduced, so that a thickness of a part of the first housing 11 on which the camera 14 is mounted can be reduced. If a thickness of the second connecting portion 404b is reduced, space requirements of the second connecting portion 404b, the third connector 16, and the second circuit board 221 in the Z-axis direction are reduced, so that a thickness of a part of the first housing 11 on which the second circuit board 221 is mounted can be reduced. This is conducive to the light and thin design of the first housing 11.

The foregoing descriptions are merely a part of embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A flexible printed circuit, comprising: a first substrate, a second substrate, and a first bonding adhesive, wherein in a thickness direction of the flexible printed circuit, the first substrate and the second substrate are laminated, and the first bonding adhesive is bonded between the first substrate and the second substrate;
the first substrate comprises a first flexible board, and the first flexible board comprises a first support layer and a first circuit layer; the second substrate comprises a second flexible board and a second cover layer; in the thickness direction of the flexible printed circuit, the first circuit layer and the first support layer are laminated, the first circuit layer comprises a plurality of first wires, and a first gap is provided between each two adjacent first wires; the second flexible board and the second cover layer are laminated; and
the first bonding adhesive is bonded between the first support layer and the second flexible board, and the first bonding adhesive fills the first gap and covers the first wires.

2. The flexible printed circuit according to claim 1, wherein the first substrate further comprises a first cover layer, and the first cover layer is provided with an avoidance notch; in the thickness direction of the flexible printed circuit, the first cover layer and the first flexible board are laminated, the avoidance notch runs through the first cover layer, and a part of the first wires, a part of the first gap, and a part of the first support layer are opposite to the avoidance notch; and
the first bonding adhesive comprises a first bonding segment, the first bonding segment is arranged in the avoidance notch, the first bonding segment is bonded between the first support layer and the second flexible board, and the first bonding segment fills a first gap directly facing the avoidance notch and completely covers the first wire directly facing the avoidance notch.

3. The flexible printed circuit according to claim 2, wherein the first bonding adhesive further comprises a second bonding segment, the second bonding segment is connected to the first bonding segment in a length direction of the flexible printed circuit, and the second bonding segment is bonded between the first cover layer and the second flexible board.

4. The flexible printed circuit according to claim 3, wherein in the length direction of the flexible printed circuit, a length of the second bonding segment is greater than 0.5 mm.

5. The flexible printed circuit according to claim 2, wherein in the thickness direction of the flexible printed circuit, a thickness of the first cover layer is greater than a thickness of the first circuit layer, and the thickness of the first cover layer is less than 30 µm; and a thickness of the first bonding adhesive is greater than the thickness of the first circuit layer, and the thickness of the first bonding adhesive ranges from 15 µm to 25 µm.

6. The flexible printed circuit according to claim 2, wherein the first cover layer comprises a first cover adhesive and a first protective layer; and in the thickness direction of the flexible printed circuit, the first cover adhesive is bonded between the first protective layer and the first support layer, and the first cover adhesive fills the first gap and covers the first wires.

7. The flexible printed circuit according to claim 6, wherein the second flexible board comprises a second support layer and a second circuit layer, and the second cover layer comprises a second cover adhesive and a second protective layer; the first bonding adhesive is bonded between the first support layer and the second support layer;
in the thickness direction of the flexible printed circuit, the second support layer and the second circuit layer are laminated, the second circuit layer comprises a plurality of second wires, and a second gap is provided between each two adjacent second wires; and the second cover adhesive is bonded between the second protective layer and the second support layer, and the second cover adhesive fills the second gap and completely covers the second wires.

8. The flexible printed circuit according to any one of claims 2 to 7, wherein in the thickness direction of the flexible printed circuit, a first spacing is provided between the first cover layer and the second flexible board; and in the length direction of the flexible printed circuit, the first spacing and the first bonding adhesive are sequentially arranged.

9. The flexible printed circuit according to claim 8, wherein the flexible printed circuit further comprises a third substrate and a second bonding adhesive, the third substrate is laminated on a side of the first substrate facing away from the second substrate, and the second bonding adhesive is bonded between the first substrate and the third substrate; and
the third substrate comprises a third flexible board and a third cover layer, the third flexible board and the third cover layer are laminated in the thickness direction of the flexible printed circuit, the second bonding adhesive is bonded between the third flexible board and the first support layer, and the second bonding adhesive is opposite to the first bonding adhesive.

10. The flexible printed circuit according to claim 9, wherein the third flexible board comprises a third support layer and a third circuit layer, and the third cover layer comprises a third cover adhesive and a third protective layer; the second bonding adhesive is bonded between the first support layer and the third support layer;
in the thickness direction of the flexible printed circuit, the third support layer and the third circuit layer are laminated, the third circuit layer comprises a plurality of third wires, and a third gap is provided between each two adjacent third wires; and the third cover adhesive is bonded between the third protective layer and the third support layer, and the third cover adhesive fills the third gap and completely covers the third wires.

11. The flexible printed circuit according to claim 9, wherein a second spacing is provided between the third flexible board and the first support layer; in the thickness direction of the flexible printed circuit, the second spacing is opposite to the first spacing; and in the length direction of the flexible printed circuit, the second spacing and the second bonding adhesive are sequentially arranged.

12. The flexible printed circuit according to any one of claims 2 to 7, wherein two avoidance notches are provided, the two avoidance notches are a first notch and a second notch, and in the length direction of the flexible printed circuit, the first notch and the second notch are spaced apart; and two first bonding adhesives are provided, and the two first bonding adhesives are respectively arranged in the first notch and the second notch.

13. The flexible printed circuit according to any one of claims 2 to 7, wherein a plurality of first substrates are provided, and in the thickness direction of the flexible printed circuit, the plurality of first substrates are sequentially laminated, and a first support layer of each of the first substrates is opposite to a first cover layer of an adjacent first substrate; and a first cover layer of each of the first substrates is provided with an avoidance notch, and the first bonding adhesive is arranged in each of the avoidance notches.

14. An electronic device, comprising a first main body, a second main body, a rotating mechanism, and the flexible printed circuit according to any one of claims 1 to 13, wherein the rotating mechanism is connected between the first main body and the second main body; the flexible printed circuit is arranged on the first main body, the rotating mechanism, and the second main body, to cause the first main body to be electrically connected to the second main body; and when the rotating mechanism rotates, the first main body and the second main body are unfolded or folded relative to each other.

15. An electronic device, comprising a housing, a camera, a circuit board, and the flexible printed circuit according to any one of claims 1 to 13, wherein the camera, the flexible printed circuit, and the circuit board are mounted on the housing, and the camera and the circuit board are electrically connected through the flexible printed circuit.
